# EUROPÄISCHE PATENTSCHRIFT

(11) **EP 1 777 268 B1**
(45) Veröffentlichungstag und Bekanntmachung des Hinweises auf die Patenterteilung: **20.01.2010**
(21) Anmeldenummer: 06014212.2
(22) Anmeldetag: 08.07.2006
(51) Int. Cl.: C09B 67/22, C09D 11/00, G03F 7/00, G02B 5/22, C09B 67/20

(54) **Organische Pigmente für Farbfilter**
Organic pigments for colour filter
Pigments organiques pour filtres colorés

(30) Priorität: 19.07.2005 DE 102005033581
(43) Veröffentlichungstag der Anmeldung: 25.04.2007
(73) Patentinhaber: LANXESS Deutschland GmbH, 51369 Leverkusen (DE)
(72) Erfinder: Feldhues, Ulrich, Dr., 51465 Bergisch Gladbach (DE); Linke, Frank, 51069 Köln (DE); Göbel, Ronald, 51371 Leverkusen (DE); Pfützenreuter, Dirk, 51399 Burscheid (DE); Herrmann, Udo, Dr., 41541 Dormagen (DE)

(56) Entgegenhaltungen:
- EP-A- 0 994 162
- EP-A- 1 146 087
- EP-A- 1 348 738
- DE-A1- 10 213 980
- DE-A1- 19 847 586

## Beschreibung

Die Erfindung betrifft die Verwendung von speziellen Nickel-Azopigmenten der Formel (I), die Melamin eingelagert enthalten, zur Herstellung von Farbfiltern für Flüssigkristallanzeigen, sowie die genannten Pigmente enthaltende Farbfilter und die sie enthaltenden Flüssigkristallanzeigen.

Farbfilter finden heute vornehmlich Anwendung in Flüssigkristallanzeigen, -bildschirmen, Farbauflösungsgeräten und Sensoren. Ein bekanntes Beispiel sind die Flachbildschirme bei Personalcomputern. Es gibt verschiedene Methoden zur Herstellung der Farbfilter, die sich sowohl in der Auftragung der Farben als auch der Erzeugung der Farbelementmuster der Basisfarben rot, grün und blau neben schwarz unterscheiden. Die Applikation bzw. Auftragung der Farben kann z.B. durch Einfärben einer Trägerschicht (z.B. Gelatine) mittels löslichen Farbstoffen oder Pigmenten ("Dye Method", "Dye Dispersion Method"), Siebdruck, Offsetdruck oder Tintenstrahldruck von Pigmentpasten, -präparationen oder -tinten, Elektrodeposition von Photolacken auf Basis von Farbstoffen oder Pigmenten sowie insbesondere mittels der Pigment-Dispersionsmethode, bei der Pigmente verwendet werden, die entweder in einem Polyimidharz ("nicht-photosensitive Polyimidmethode") oder in einem Photolack ("photosensitive Acrylmethode") dispergiert sind, erfolgen. Verbunden mit den genannten Verfahren kommt sowohl der drucktechnisch direkten Erzeugung der Farbelementmuster als auch der indirekten, photolithographischen Erzeugung Bedeutung zu, letztere insbesondere bei der o.g. Pigmentdispersionsmethode. Die Technik der Pigment-Dispersionsmethode in Form der "nicht-photosensitiven Polyimidmethode" ist beispielsweise in JP-A-11-217514 (1998) offenbart.

Bei der Pigment-Dispersionsmethode nach dem Photolackverfahren liegen die farbgebenden Pigmente in einem UV-härtbaren Photolack feinverteilt (dispergiert) vor. Der Photolack besteht dabei neben dem Pigment im Allgemeinen aus den Komponenten Bindemittelharz, polymerisierbares Monomer, Photoinitiator sowie gegebenenfalls einem Lösungsmittel. Die Herstellung erfolgt z.B. derart, dass zunächst das Pigment in Form eines Konzentrates, Lösungsmittel und gegebenenfalls Bindemittelharz feinteilig dispergiert wird und unmittelbar vor der Applikation zusammen mit dem Monomer und dem Photoinitiator sowie gegebenenfalls weiteren Komponenten eingestellt wird. Der pigmentierte Fotolack wird auf das Substrat, z.B. Glass, gleichmäßig aufgetragen, z.B. mittels dem sogenannten "spin coating"- Verfahren, vorgetrocknet, mittels einer Fotomaske UV belichtet, mittels einer in der Regel anorganisch alkalischen Lösung zu den gewünschten Farbelementmustern entwickelt, die Beschichtung gereinigt und gegebenenfalls nachgehärtet. Dieser Prozess wird für jede Farbe wiederholt, in der Regel also 3 mal für eine Trichromie z.B. in den Farben rot, grün und blau.

Die Vorteile bei der Verwendung von Pigmenten in Verbindung mit der Pigment-Dispersionsmethode liegen in der verbesserten Licht-, Feuchtigkeits- und Temperaturbeständigkeit der Farbfilter im Vergleich zu farbstoff-basierenden Beschichtungssystemen. Demgegenüber sind die Transparenz und Farbreinheit der Beschichtungen auf Basis von Pigmenten, unabhängig vom Beschichtungsverfahren, noch nicht zufriedenstellend. Insbesondere wenn verschiedene Pigmente in Mischung zur Nuancierung auf die gewünschten Farbortwerte im Fotolack eingearbeitet werden, kommt es zu unerwünschten Brillianz- und Transparenzverlusten, so dass als Folge die Anzeigen bzw. Bildschirme (LCD) mit einem erhöhten Energieaufwand betrieben werden müssen.

Aus EP-A-947563 sind spezielle Azopyrazolone für den Einsatz in Farbfiltern beschrieben.

In EP 0994162 und in DE 10328999 werden Nickel-Azopigmente beansprucht, die eine Dispergierhärte < 250 (nach DIN 53775) aufweisen. Es wird ihre Verwendung für prinzipiell alle Pigmentanwendungszwecke beansprucht. Die Vorteile der Nickel-Azopigmente mit einer Dispergierhärte <250 bei der Verwendung u.a. zur Herstellung von Druckfarben, Leimfarben oder Binderfarben, zur Massefärbung von synthetischen, halbsynthetischen oder natürlichen makromolekularen Stoffen und zum Bedrucken von Textilien und Papier wird an Beispielen belegt.

In US 6596446 wird die Verwendung von Nickel-Azopigmenten für Farbfilter in LCD und Verfahren zu ihrer Herstellung beschrieben. Die in US 6596446 beanspruchten Nickel-Azopigmente für Farbfilter in LCD sind bezüglich ihrer Dispergierhärte prinzipiell nicht eingeschränkt. In US 6596446 wird ein bevorzugter Dispergierhärten-Bereich von < 250 beansprucht.

Bevorzugt setzt sich die gelbgrüne Farbkomponente aus dem CI Pigment Green 36 und einem gelben Metallazopigment zusammen. Zur besseren Kombinierbarkeit mit den übrigen Farbtönen ist eine möglichst chromatische und transparente gelbgrüne Farbkomponente vorteilhaft. Dafür muss das gelbe Pigment möglichst chromatisch und transparent sein.

Es wurde nun gefunden, dass man die beschriebenen Eigenschaften des grünen Farbtons deutlich verbessern kann, wenn als Gelbkomponente das erfindungsgemäß verwendete Pigment eingesetzt wird.

Die Erfindung betrifft die Verwendung von Pigmenten der Formel (I) 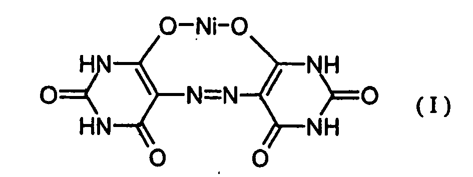 oder tautomere Strukturen davon und/oder Hydrate davon, die Melamin eingelagert enthalten, als Pigmente für Farbfilter für Flüssigkristallanzeigen, dadurch gekennzeichnet, dass die genannten Pigmente eine Dispergierhärte von mehr als 250 aufweisen. (Erfindungsgemäß wird die Dispergierhärte nach DIN 53775 gemessen.)

Es zeigt sich überraschend, dass die genannten Pigmente mit Dispergierhärten von mehr als 250 überraschend eine höhere Transparenz und Farbreinheit aufweisen.

In einer bevorzugten Ausführungsform wird das genannte erfindungsgemäß verwendete Pigment zusammen mit dem Pigment "Pigment Green 36" verwendet.

Bevorzugt eingelagert werden 10 bis 100 Gew.-% Melamin bezogen auf die Gesamtmenge des Pigments. Es handelt sich hierbei um die Menge an Melamin, die durch geeignete Lösungsmittel nicht auswaschbar ist und die sich aus der Elementaranalyse ergibt. Naturgemäß kann auch mehr oder weniger als die genannte Menge an Melamin zugesetzt werden, wobei man gegebenenfalls darauf verzichten kann, einen Überschuss auszuwaschen. Bevorzugt sind Mengen von 10 bis 150 Gew.-%.

Besonders bevorzugt ist der Azobarbitursäure-Nickel-1:1-Komplex der Formel (I) oder eine seiner tautomeren Formen, der zwei Moleküle Melamin pro Atom Nickel eingeschlossen enthält. Im Rahmen dieser Anmeldung sind auch immer die Hydrate der genannten Pigmente mitumfasst.

Ganz besonders bevorzugt für die Verwendung für Farbfilter in LCD sind getemperte, vorzugsweise bei pH 2,5 ― pH 3,5, insbesondere bei pH 2,7 ― pH 3,3 getemperte Azobarbitursäure-Nickel-1:1-Komplexe der Formel (I), die Melamin eingeschlossen enthalten. Eine verbesserte Farbstärke kann dadurch erreicht werden, dass eine Temperung in wenigstens zwei pH-Stufen im Bereich von 0 bis 4 erfolgt.

Im Rahmen dieser Anmeldung werden die Nickel-Komplexe der Azoverbindungen der Formel (I), die Melamin eingelagert enthalten und eine Dispergierhärte > 250 (nach DIN 53775) aufweisen, als erfindungsgemäß verwendete Pigmente bezeichnet. Vorzugsweise haben die Nickel-Komplexpigmente eine Dispergierhärte >250 und <1000, insbesondere >300 und <500.

Eine Dispergierhärte von > 1000 resultiert zwar ebenfalls in der gewünschten Transparenz, kann aber zu anwendungstechnischen Problemen, insbesondere zu einer Verringerung der Lagerstabilität der Pigmentdispersionen führen und ist aus diesem Grund weniger bevorzugt.

Die Dispergierhärte wird gemessen nach DIN 53775, Teil 7, wobei die Temperatur der Kaltwalzung 25°C und die der Warmwalzung 150°C beträgt. Sämtliche in dieser Anmeldung angegebenen Dispergierhärten wurden nach dieser modifizierten DIN-Vorschrift bestimmt.

Das Pigment besitzt vorzugsweise eine spezifische Oberfläche von 120 bis 180 m²/g, insbesondere 130 bis 170 m²/g, besonders bevorzugt 140 bis 160 m²/g, ganz besonders bevorzugt 150 bis 160 m²/g. Vergleichsweise hohe spezifische Oberflächen und eine verbesserte Reproduzierbarkeit lassen sich durch die Verwendung von Impfkristallen oder den Einsatz einer Umpumpung bei der Herstellung der Pigmente erzielen.

Die Oberfläche wird nach DIN 66131 ermittelt: Bestimmung der spezifischen Oberfläche von Feststoffen durch Gasadsorption nach Brunauer, Emmett und Teller (B.E.T.)

Es ist für den Fachmann besonders überraschend, dass die erfindungsgemäße Verwendung der Pigmente, die eine Dispergierhärte von >250 aufweisen, in der Herstellung von Farbfiltern Vorteile aufweisen.

Dies ist umso überraschender, als die in EP 0994162 und in DE 10328999 beschriebenen speziellen Nickel-Azopigmente umso bevorzugter beansprucht werden, je niedriger (bevorzugt <200, insbesondere <150) die Dispergierhärte der Nickel-Azopigmente ist.

Die in EP 0994162 und in DE 10328999 beschriebenen speziellen Nickel-Azopigmente, die eine Dispergierhärte < 250 (nach DIN 53775) aufweisen, sind bereits wertvolle Pigmente und lassen sich sehr gut verarbeiten, erreichen aber in Farbfiltern keine optimale Transparenz.

Die Herstellung der erfindungsgemäßen Nickel-Azopigmente kann so erfolgen, dass vorzugsweise ein Alkalisalz wie Na-, Li- oder insbesondere K-Salz der Azobarbitursäure in einem wässrigen System mit Melamin und einem Nickelsalz in beliebiger Reihenfolge umgesetzt wird und dann vorzugsweise bei pH 2,5 - pH 3,5, insbesondere bei pH 2,7 - pH 3,3 getempert wird. Insbesondere durch Wahl der Bedingungen der Temperung (pH-Wert, Temperatur und Dauer) kann dabei die Dispergierhärte im gewünschten Bereich eingestellt werden, wie dem Fachmann an sich bekannt ist. Die Bedingungen der Temperung werden vorteilhaft an die Dispergierhärte des bei der Synthese zunächst entstandenen Materials angepasst.

Die erfindungsgemäße Verwendung der oben beschriebenen Pigmente bzw. die der erfindungsgemäßen Pigmentpräparationen zur Herstellung von Farbfiltern für Flüssigkristallanzeigen sei im Folgenden am Beispiel der Pigment-Dispersionsmethode nach dem Photolackverfahren beschrieben.

Die erfindungsgemäße Verwendung der erfindungsgemäßen Pigmentpräparationen zur Herstellung von Farbfiltern ist beispielsweise dadurch gekennzeichnet, dass das "Pigment" oder die Pigmentpräparation, insbesondere die feste Pigmentpräparation, gegebenenfalls mit einem Bindemittelharz und einem organischen Lösungsmittel, gegebenenfalls unter Zusatz eines Dispergiermittels, homogenisiert und anschließend kontinuierlich oder diskontinuierlich auf eine Teilchengröße nach Anzahl (elektronenmikroskopische Bestimmung) von 99,5 % <1000 nm, vorzugsweise 95 % <500 nm und insbesondere 90 % <200 nm nasszerkleinert wird. Als Nasszerkleinerungsverfahren kommen beispielsweise Rührer- oder Dissolverdispergierung, Mahlen mittels Rührwerkskugel- oder -perlmühlen, Kneter, Walzenstuhl, Hochdruckhomogenisierung oder Ultraschalldispergierung in Frage.

Während der Dispergierbehandlung oder im Anschluss daran erfolgt die Zugabe von mindestens einem photohärtbaren Monomeren und einem Photoinitiator. Im Anschluss an die Dispergierung kann noch weiteres Bindemittelharz, Lösungsmittel oder für Photolacke übliche Zuschlagstoffe eingebracht werden, wie es für die gewünschte photosensitive Beschichtungsmitteleinstellung (Photolack) zur Herstellung der Farbfilter erforderlich ist. Im Rahmen dieser Erfindung wird unter Photolack eine Präparation verstanden, die wenigstens ein photohärtbares Monomer und einen Photoinitiator zusätzlich zum genannten Pigment enthält.

Als mögliche Dispergiermittel kommen allgemein handelsübliche wie beispielsweise polymere, ionogene oder nicht-ionogene Dispergiermittel bspw. auf Basis von Polycarbonsäuren oder Polysulfonsäuren, sowie Polyethylenoxid-Polypropylenoxid-Block-Copolymere in Betracht. Ferner können auch Derivate organischer Farbstoffe als Dispergiermittel oder Co-Dispergiermittel verwendet werden.

Bei der Herstellung der Farbfilter fallen daher "Zubereitungen" an, die bezogen auf die Zubereitung enthalten:
- wenigstens ein Nickelsalz der Formel (I), welches Melamin eingelagert enthält und eine Dispergierhärte > 250 aufweist, und im Sinne dieser Anmeldung als erfindungsgemäßes Pigment bezeichnet wird,
- gegebenenfalls ein Bindemittelharz,
- wenigstens ein organisches Lösungsmittel sowie
- gegebenenfalls ein Dispergiermittel.

In einer bevorzugten Ausführungsform enthält die Zubereitung (Angaben bezogen auf Zubereitung):

| | |
|---|---|
| 1 - 50 Gew.-% | ein Pigment im obigen Sinne |
| 0 - 20 Gew.-% | Bindemittelharz |
| 0 - 20 Gew.-% | Dispergiermittel |
| 10 - 94 Gew.-% | organisches Lösungsmittel. |

Die Beschichtung des Photolackes auf eine Platte zur Erzeugung der gefärbten Bildelementmuster kann entweder durch direkten oder indirekten Auftrag geschehen. Als Auftragsmethoden seien bspw. genannt: Roller-Coating, Spin-Coating, Spray-Coating, Dip-Coating und Air-Knife-Coating.

Als Platten kommen je nach Verwendung beispielsweise in Frage: transparente Gläser wie weiße oder blaue Glasplatte, mit Silikat beschichtete blaue Glasplatte, Kunstharzplatte oder -filme auf Basis von z.B. Polyester-, Polycarbonat-, Acryl-, oder Vinylchloridharz, ferner Metallplatten auf Basis von Aluminium, Kupfer, Nickel, oder Stahl sowie Keramikplatten oder Halbleiterplatten mit aufgebrachten photoelektrischen Transferelementen.

Die Auftragung erfolgt im Allgemeinen so, dass die Schichtdicke der erhaltenen photosensitiven Schicht bei 0,1 bis 10 µm liegt.

Im Anschluss an den Auftrag kann eine thermische Trocknung der Schicht erfolgen.

Die Belichtung erfolgt vorzugsweise, indem die photosensitive Schicht einem aktiven Lichtstrahl vorzugsweise in Form eines Bildmusters mittels Photomaske ausgesetzt wird. Hierdurch wird an den belichteten Stellen die Schicht gehärtet. Geeignete Lichtquellen sind z.B.: Hochdruck- und Ultrahochdruckquecksilberdampflampe, Xenon-, Metallhalogenid-, Fluoreszenzlampe sowie Laserstrahl im sichtbaren Bereich.

Durch die Entwicklung im Anschluss an die Belichtung wird der unbelichtete Teil der Beschichtung entfernt und man erhält die gewünschte Bildmusterform der Farbelemente. Übliche Entwicklungsmethoden umfassen das Besprühen mit oder Tauchen in wässrige alkalische Entwicklerlösung oder in ein organisches Lösungsmittel, das anorganische Alkali wie z.B. Natrium- oder Kaliumhydroxid, Natriummetasilikat oder organische Basen wie Monoethanolamin, Diethanolamin, Triethanolamin, Triethylamin oder deren Salze enthält.

Nach der Entwicklung erfolgt in der Regel eine thermische Nachtrocknung/-härtung der Bildmuster.

### Weitere Pigmente:

Die Verwendung der "Pigmente" im obigen Sinne ist vorzugsweise dadurch gekennzeichnet, dass diese alleine oder in Mischung mit "anderen Pigmenten" in den Farbfiltern bzw. Pigmentpräparationen oder Zubereitung für Farbfilter eingesetzt werden.

Unter "andere Pigmente" seien sowohl andere Metallsalze einer Azo-Verbindung der Formel (I) oder darauf basierende Pigmentpräparationen verstanden als auch andere organische Pigmente.

Hinsichtlich der Auswahl anderer gegebenenfalls mitzuverwendender Pigmente besteht erfindungsgemäß keine Einschränkung. Es kommen sowohl anorganische als auch organische Pigmente in Frage.

Bevorzugte organische Pigmente sind z.B. solche der Monoazo-, Disazo-, verlackte Azo-, β-Naphthol-, Napthol AS-, Benzimidazolon-, Disazokondensations-, Azometallkomplex-, Isoindolin- und Isoindolinon-Reihe, ferner polycyclische Pigmente wie z.B. aus der Phthalocyanin-, Chinacridon-, Perylen-, Perinon-, Thioindigo-, Anthrachinon-, Dioxazin-, Chinophthalon- und Diketopyrrolopyrrol-Reihe. Außerdem verlackte Farbstoffe wie Ca-, Mg- und Al-Lacke von sulfonsäure- oder carbonsäuregruppenhaltigen Farbstoffen.

Beispiele für gegebenenfalls mitzuverwendende andere organische Pigmente sind:
gelbe Pigmente vom
Colour Index Pigment Yellow 12, 13, 14, 17, 20, 24, 74, 83, 86, 93, 94, 109, 110, 117, 125, 137, 138, 139, 147, 148, 150, 153, 154, 166, 173, 185, oder
Colour Index Pigment Orange 13, 31, 36, 38, 40, 42, 43, 51, 55, 59, 61, 64, 65, 71, 72, 73 oder
Colour Index Pigment Red 9, 97, 122, 123, 144, 149, 166, 168, 177, 180, 192, 215, 216, 224, 254, 272, oder
Colour Index Pigment Green 7, 10, 36, 37, 45, oder
Colour Index Pigment Blue 15, 15:1, 15:2, 15:3, 15:4, 15:6, 16 sowie
Colour Index Pigment Violett 19, 23.

Sofern "andere Pigmente" zusätzlich eingesetzt werden, beträgt der Anteil von "Pigment" im obigen Sinne vorzugsweise 1-99 Gew.-%, insbesondere 20-80 Gew.-% bezogen auf die eingesetzte Gesamtmenge aller Pigmente.

Besonders bevorzugt sind die erfindungsgemäßen Pigmentpräparationen sowie Zubereitungen, enthaltend "Pigmente" im obigen Sinne und C.I. Pigment Green 36 im Verhältnis von 20 bis 80 % "Pigment" zu 80 bis 20 % C.I. Pigment Green 36, vorzugsweise von 40 bis 60 % zu 60 bis 40 %.

Als Bindemittelharze, die zusammen mit dem "Pigment" oder darauf basierender Pigmentpräparationen in Farbfiltern bzw. in den Zubereitungen zur Herstellung von Farbfiltern z.B. nach der Pigment-Dispersionsmethode, eingesetzt werden können, besteht erfindungsgemäß keine besondere Einschränkung, insbesondere kommen für die Anwendung in Farbfiltern an sich bekannte filmbildende Harze in Frage.

Beispielsweise kommen Bindemittelharze aus der Gruppe der Celluloseharze wie Carboxymethylhydroxyethylcellulose und Hydroxyethylcellulose, Acrylharze, Alkydharze, Melaminharze, Epoxidharze, Polyvinylalkohole, Polyvinylpyrrolidone, Polyamide, Polyamidimine, Polyimide, Polyimidvorstufen wie solche der Formel (14), offenbart in JP-A 11 217 514 und deren Veresterungsprodukte in Frage.

Als solche sind beispielsweise Umsetzungsprodukte von Tetracarbonsäuredianhydrid mit Diaminen zu nennen.

Als Bindemittelharze kommen auch solche in Frage, die photopolymerisierbare, ungesättigte Bindungen enthalten. Die Bindemittelharze können beispielsweise solche aus der Gruppe der Acrylharze sein. Dabei sind insbesondere Mono- und Copolymere polymerisierbarer Monomere zu nennen wie z.B. (Meth)acrylsäuremethylester, (Meth)acrylsäureethylester, (Meth)acrylsäurepropylester, (Meth)acrylsäurebutylester, Styrol und Styrolderivate, ferner Copolymere zwischen carboxylgruppentragenden polymerisierbaren Monomeren wie (Meth)acrylsäure, Itaconsäure, Maleinsäure, Maleinsäureanhydrid, Maleinsäuremonoalkylester, insbesondere mit Alkyl von 1 bis 12 C-Atomen, und polymerisierbare Monomere wie (Meth)acrylsäure, Styrol und Styrolderivate, wie z.B. α-Methylstyrol, m- oder p-Methoxystyrol, p-Hydroxystyrol. Als Beispiele seien genannt Umsetzungsprodukte von carboxylgruppenhaltigen polymeren Verbindungen mit Verbindungen, die jeweils einen Oxiranring und eine ethylenisch ungesättigte Bindung enthalten wie z.B. Glycidyl(meth)acryl, Acrylatglycidylether und Itaconsäuremonoalkylglycidylester usw., ferner Umsetzungsprodukte von carboxylgruppenhaltigen polymeren Verbindungen mit Verbindungen, die jeweils eine Hydroxylgruppe und eine ethylenisch ungesättigte Bbindung (ungesättigte Alkohole) enthalten wie Allylalkohol, 2-Buten-4-ol, Oleylalkohol, 2-Hydroxyethyl(meth)acrylat, N-Methylolacrylamid usw.;
weiterhin können derartige Bindemittelharze auch ungesättigte Verbindungen, die freie Isocyanatgruppen besitzen, enthalten.

Im Allgemeinen liegt die Äquivalenz der Ungesättigtheit (Molgewicht Bindemittelharz pro ungesättigte Bindung) der genannten Bindemittelharze bei 200 bis 3 000, insbesondere 230 bis 1 000, um sowohl eine ausreichende Photopolymerisierbarkeit und Härte des Films zu erreichen. Der Säurewert liegt im Allgemeinen bei 20 bis 300, insbesondere 40 bis 200, um eine genügende Alkali-Entwicklungsfähigkeit nach der Belichtung des Films zu erzielen.

Das mittlere Molgewicht der einzusetzenden Bindemittelharze liegt zwischen 1 500 und 200 000, insbesondere 10 000 bis 50 000 g/mol.

Die bei der erfindungsgemäßen Verwendung der Pigmentpräparationen für Farbfilter eingesetzten organischen Lösungsmittel sind z.B. Ketone, Alkylenglykolether, Alkohole und aromatische Verbindungen. Beispiele aus der Gruppe der Ketone sind: Aceton, Methylethylketon, Cyclohexanon etc.; aus der Gruppe der Alkylenglykolether: Methylcellosolve (Ethylenglykolmonomethylether), Butylcellosolve (Ethylenglykolmonobutylether), Methylcellosolveacetat, Ethylcellosolveacetat, Butylcellosolveacetat, Ethylenglykolmonopropylether, Ethylenglykolmonohexylether, Ethylenglykoldimethylether, Diethylenglykolethylether, Diethylenglykoldiethylether, Propylenglykolmonomethylether, Propylenglykolmonoethylether, Propylenglykolmonopropylether, Propylenglykolmonobutylether, Propylenglykolmonomethyletheracetat, Diethylenglykolmethyletheracetat, Diethylenglykolethyletheracetat, Diethylenglykolpropyletheracetat, Diethylenglykolisopropyletheracetat, Diethylenglykolbutyletheracetat, Diethylenglykol-t-butyletheracetat, Triethylenglykolmethyletheracetat, Triethylenglykolethyletheracetat, Triethylenglykolpropyletheracetat, Triethylenglykolisopropyletheracetat, Triethylenglykolbutyletheracetat, Triethylenglykol-t-butyletheracetat, etc.; aus der Gruppe der Alkohole: Methylalkohol, Ethylalkohol, Isopropylalkohol, n-Butylalkohol, 3-Methyl-3-methoxybutanol, etc.; aus der Gruppe der aromatischen Lösungsmittel Benzol, Toluol, Xylol, N-Methyl-2-Pyrrolidon, N-Hydroxymethyl-pyrrolidon-2-essigsäureethylester, etc.

Weitere andere Lösungsmittel sind 1,2-Propandioldiacetat, 3-Methyl-3-methoxybutylacetat, Essigsäureethylester, Tetrahydrofuran, etc. Die Lösungsmittel können einzeln oder in Gemischen untereinander eingesetzt werden.

Die Erfindung betrifft weiterhin einen Photolack, enthaltend wenigstens ein Pigment im obigen Sinne oder wenigstens eine erfindungsgemäße Pigmentpräparation und wenigstens ein photohärtbares Monomer sowie wenigstens einen Photoinitiator.

Die photohärtbaren Monomere enthalten im Molekül wenigstens eine reaktive Doppelbindung und gegebenenfalls andere reaktive Gruppen.

Als photohärtbare Monomere seien in diesem Zusammenhang insbesondere reaktive Lösungsmittel bzw. sog. Reaktivverdünner verstanden z.B. aus der Gruppe der mono-, di-, tri- und multifunktionelle Acrylate und Methacrylate, Vinylether, sowie Glycidylether. Als zusätzlich enthaltene reaktive Gruppen kommen in Frage Allyl-, Hydroxy-, Phosphat-, Urethan-, sek. Amin- und N-Alkoxymethylgruppen.

Derartige Monomere sind dem Fachmann bekannt und beispielsweise in *[*Römpp Lexikon, Lacke und Druckfarben, Dr. Ulrich Zorll, Thieme Verlag Stuttgart-New York, 1998, S. 491/492*]* aufgeführt.

Die Auswahl der Monomere richtet sich insbesondere nach der Art und Intensität der verwendeten Strahlenart der Belichtung, der gewünschten Reaktion mit dem Photoinitiator und den Filmeigenschaften. Es können auch Kombinationen von Monomeren eingesetzt werden.

Als Photoreaktionsstarter oder Photoinitiatoren seien Verbindungen verstanden, die infolge der Absorption sichtbarer oder ultravioletter Strahlung reaktive Zwischenprodukte bilden, die eine Polymerisationsreaktion beispielsweise der oben genannten Monomeren und/oder Bindemittelharze auslösen können. Photoreaktionsstarter sind ebenfalls allgemein bekannt und können ebenfalls aus *[*Römpp Lexikon, Lacke und Druckfarben, Dr. Ulrich Zorll, Thieme Verlag Stuttgart-New York, 1998, S. 445/446*]* entnommen werden.

Erfindungsgemäß besteht keine Einschränkung hinsichtlich der einzusetzenden photohärtbaren Monomeren oder Photoinitiatoren.

Die Erfindung betrifft bevorzugt Photolacke enthaltend
A) wenigstens ein "Pigment" im obigen Sinne, insbesondere in Mischung mit anderen Pigmenten, vorzugsweise C.I. Pigment Green 36 oder eine darauf basierende erfindungsgemäße Pigmentpräparation,
B1) wenigstens ein photohärtbares Monomer,
B2) wenigstens einen Photoinitiator,
C1) gegebenenfalls ein organisches Lösungsmittel,
D) gegebenenfalls ein Dispergiermittel,
E) gegebenenfalls ein Bindemittelharz,
sowie gegebenenfalls weitere Zusätze.

Erfindungsgemäß besteht auch keine Einschränkung hinsichtlich der Technologie zur Erzeugung der gefärbten Bildelementmuster auf Basis der erfindungsgemäß zu verwendenden Pigmente oder festen Pigmentpräparationen. Neben dem oben beschriebenen photolithographischen Verfahren sind andere Verfahren wie Offset-Druck, chemisches Ätzen oder Ink Jet Druck ebenso geeignet. Die Auswahl der geeigneten Bindemittelharze und Lösungsmittel bzw. Pigment-Trägermedien sowie weitere Zusätze sind auf das jeweilige Verfahren abzustimmen. Beim Ink Jet Verfahren, worunter sowohl der thermische als auch mechanische und piezo-mechanische Ink Jet Druck verstanden werden, kommen neben rein organischen auch wässrig-organische Trägermedien für die Pigmente und gegebenenfalls Bindemittelharze in Frage, wässrig-organische Trägermedien werden sogar bevorzugt.

### Beispiele

### Herstell-Beispiel 1 nicht erfindungsgemäßes Pigment

1 Mol Diazobarbitursäure werden in 8 Liter 90°C-heißem Wasser mit 1 Mol Barbitursäure unter KOH-Titration bei pH 5 umgesetzt. 2 Mol Melamin werden zugegeben. Der pH wird mit Salzsäure auf 5 gestellt. 1 Mol einer 40%igen Nickelchloridlösung werden zugetropft. Nach 1h bei 90°C wird mit KOH auf pH 5 gestellt. Danach wird mit Salzsäure auf pH 2,0 gestellt und 4h bei 98°C getempert. Danach wird mit KOH auf pH 5 gestellt. Anschließend wird das Pigment auf einer Saugnutsche isoliert, gewaschen und bei 80°C im Vakuumtrockenschrank getrocknet und in einer üblichen Labormühle ca. 2 Minuten gemahlen.

| | | | |
|---|---|---|---|
| Dispergierhärte: | 220 | BET: | 120m²/g |

### Herstell-Beispiel 2 erfindungsgemäßes Pigment

1 Mol Diazobarbitursäure werden in 8 Liter 90°C-heißem Wasser mit 1 Mol Barbitursäure unter KOH-Titration bei pH 5 umgesetzt. 2 Mol Melamin werden zugegeben. Der pH wird mit Salzsäure auf 5 gestellt. 1 Mol einer 40%igen Nickelchloridlösung werden zugetropft. Nach 1h bei 90°C wird mit KOH auf pH 5 gestellt. Danach wird mit Salzsäure auf pH 3,2 gestellt und 8h bei 98°C getempert. Danach wird mit KOH auf pH 5 gestellt. Anschließend wird das Pigment auf einer Saugnutsche isoliert, gewaschen und bei 80°C im Vakuumtrockenschrank getrocknet und in einer üblichen Labormühle ca. 2 Minuten gemahlen.

| | | | |
|---|---|---|---|
| Dispergierhärte: | 490 | BET: | 159m²/g |

### Herstell-Beispiel 3 erfindungsgemäßes Pigment

1 Mol Diazobarbitursäure werden in 8 Liter 90°C-heißem Wasser mit 1 Mol Barbitursäure unter KOH-Titration bei pH 5 umgesetzt. 2 Mol Melamin werden zugegeben. Der pH wird mit Salzsäure auf 5 gestellt. 1 Mol einer 40%igen Nickelchloridlösung werden zugetropft. Nach 1h bei 90°C wird mit KOH auf pH 5 gestellt. Danach wird mit Salzsäure auf pH 3,0 gestellt und 8h bei 98°C getempert. Danach wird mit KOH auf pH 5 gestellt. Anschließend wird das Pigment auf einer Saugnutsche isoliert, gewaschen und bei 80°C im Vakuumtrockenschrank getrocknet und in einer üblichen Labormühle ca. 2 Minuten gemahlen.

| | | | |
|---|---|---|---|
| Dispergierhärte: | 420 | BET: | 155 m²/g |

### Herstell-Beispiel 4 erfindungsgemäßes Pigment

1 Mol Diazobarbitursäure werden in 8 Liter 90°C-heißem Wasser mit 1 Mol Barbitursäure unter KOH-Titration bei pH 5 umgesetzt. 2 Mol Melamin werden zugegeben. Der pH wird mit Salzsäure auf 5 gestellt. 1 Mol einer 40%igen Nickelchloridlösung werden zugetropft. Nach 1h bei 90°C wird mit KOH auf pH 5 gestellt. Danach wird mit Salzsäure auf pH 3,0 gestellt und 12h bei 98°C getempert. Danach wird mit KOH auf pH 5 gestellt. Anschließend wird das Pigment auf einer Saugnutsche isoliert, gewaschen und bei 80°C im Vakuumtrockenschrank getrocknet und in einer üblichen Labormühle ca. 2 Minuten gemahlen.

| | | | |
|---|---|---|---|
| Dispergierhärte: | 390 | BET: | 152 m²/g |

### Verwendungsbeispiele 1- 4

Herstellung einer gelben Zubereitung und Verwendung zur Herstellung eines gelben Farbfilters

In einem Rührbehälter werden 774 Gew.-Teile Methoxybutylacetat und 286 Gew.-Teile einer 21%igen Lösung eines alkalisch löslichen Copolymeren (Bindemittelharz) auf Basis von Benzylmethacrylat (70T) / 2-Hydroxyethylmethacrylat (15T) / Methacrylsäure (15T), Molgewicht ca. 25.000 g/mol, in Methoxypropylacetat homogen gemischt.

Anschließend werden 100 Gew.Teile eines Pigmentes aus den Herstellbeispielen, das zuvor bei 70°C auf eine Restfeuchte von weniger als 1 Gew% getrocknet wird, homogen eingetragen.

Diese Pigmentsuspension wird in einer horizontalen, geschlossenen Perlmühle unter Einsatz von Yttrium-stabilisierten Zirkonoxid-Perlen (Durchmesser 0,6 bis 1,0 mm) in mehreren Passagen gemahlen, bis ein effektiver Partikeldurchmesser (gemessen mit Laserstreulicht-korrelationsspektroskopie an einer ca. 0,5 Gew.-% Verdünnung in Methoxypropylacetat) von weniger als 150 nm verbunden mit einer Polydispersität von weniger als 0,14 erreicht ist. (Vergleichsweise können elektronenmikroskopisch an einem getrockneten Film aus einer 1%igen Verdünnung in Methoxypropylacetat eine sehr enge Partikelgrößenverteilung mit 95% Anzahl der Teilchen unter 100 nm festgestellt werden.)

Die erhaltenen Zubereitungen zeigen eine ausreichende Lagerstabilität. Die Verwendungsbeispiele 1 - 4, in denen die Herstellbeispiele 1 - 4 eingesetzt sind, sind zur Herstellung eines Photolackes für Farbfilter nach der Pigment-Dispersionsmethode gut geeignet.

### Herstellung eines Photolacks

Zu 1000 Gew.-Teilen der so erhaltenen Zubereitungen werden 34,5 Gew.-Teile Trimethylolpropantriacrylat (monomerer Reaktivverdünner) und 13,8 Gew.Teile eines Photoreaktionsstarters auf Basis von Benzophenon und N,N'-Tetraethyl-4,4'-diaminobenzophenon im Verhältnis von 3 / 1 Gew.Teilen unter Rühren homogen eingetragen.

Man erhält einen UV-strahlungshärtbaren Photolack, der auf einem transparenten Substrat aufgetragen und zum Farbfilter entwickelt wird.

Hierzu wird der Photolack mittels Spin-Coating auf ein 300 x 350 mm großes Stück gereinigtes Borosilikatglas (Corning® 7059, Owens Corning Corp.) beschichtet und bei 110°C 5 Minuten in einem Ofen unter Reinbedingungen zu einem ca. 1,5 - 2µm dicken Film getrocknet.

Anschließend wird der Film nach Abkühlung mittels einer Negativmaske zur Erzielung des gewünschten Streifenbildmusters und einer Ultrahochdruck-Quecksilberdampflampe bei einer Dosis von 200 mJ / cm² UV-belichtet und dann mittels 0,06 %iger wässriger Kaliumhydroxidlösung bei Raumtemperatur entwickelt, mit vollentsalztem Wasser gereinigt und getrocknet. Anschließend erfolgt eine 30 minütige Nachhärtung bei 235°C in einem Ofen unter Reinbedingungen.

Die so erhaltenen gelben erfindungsgemäßen Farbfilter 2, 3 und 4, hergestellt gemäß den Verwendungsbeispielen 2 , 3 und 4 ausgehend von den Herstell-Beispielen 2, 3 und 4, besitzen gegenüber dem nicht-erfindungsgemäßen Farbfilter 1, hergestellt gemäß dem Verwendungsbeispiel 1 und ausgehend von dem Herstell-Beispiel 1, eine deutlich verbesserte spektrale Transparenz. Die Farbreinheit und Brillanz der Farbfilter 2, 3 und 4 ist ausgezeichnet.

### Verwendungsbeispiel 5

Herstellung einer grünen Zubereitung und Verwendung zur Herstellung eines grünen Farbfilters

Mit dem gleichen Verfahren wie in Verwendungsbeispiel 2 beschrieben jedoch unter Einsatz von 40 Gew.Teilen des Pigmentes gemäß Herstell-Beispiel 2 und 60 Gew.Teilen des grünen organischen Pigmentes Heliogen®Grün L9361 (Pigment Green 36, BASF AG) anstelle von 100 Gew.Teilen des getrockneten Pigmentes hergestellt nach Beispiel 2 wird eine Zubereitung mit hoher Feinverteilung und ausreichender Langzeitstabilität hergestellt, die zur Herstellung grüner Photolacke für Farbfilter sehr gut geeignet ist.

Ein wie in Verwendungsbeispiel 2 beschrieben hergestellter Photolack und damit hergestellter grüner gestreifter Farbfilter besitzt sehr gute spektrale Transparenzeigenschaften sowie ausgezeichnete Farbreinheit und Brillanz.

## Patentansprüche

1. Verwendung von Pigmenten der Formel (I) 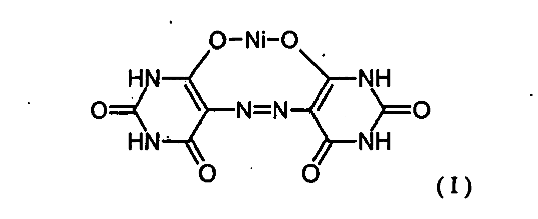 oder tautomere Strukturen davon und/oder Hydrate davon, die Melamin eingelagert enthalten, als Pigmente für Farbfilter für Flüssigkristallanzeigen, **dadurch gekennzeichnet, dass** die genannten Pigmente eine Dispergierhärte von mehr als 250 aufweisen.

2. Verwendung nach Anspruch 1, worin das Pigment zusammen mit dem Pigment "Pigment Green 36" verwendet wird.

3. Verwendung von Pigmenten gemäß Anspruch 1 oder 2, **dadurch gekennzeichnet, dass** sie pro Atom Nickel zwei Moleküle Melamin enthalten.

4. Verwendung von Pigmenten gemäß einem der Ansprüche 1 bis 3, **dadurch gekennzeichnet, dass** es sich um getemperte, vorzugsweise bei pH 2,5 - pH 3,5 getemperte Pigmente handelt.

5. Verwendung von Pigmenten gemäß einem der Ansprüche 1 bis 4, **dadurch gekennzeichnet, dass** sie eine Dispergierhärte mehr als 250 und weniger als 1000 aufweisen.

6. Verwendung von Pigmenten gemäß einem der Ansprüche 1 bis 5, **dadurch gekennzeichnet**, das sie eine spezifische Oberfläche nach BET von 120 bis 180 m²/g aufweisen.

7. Zubereitungen, enthaltend wenigstens ein Pigment, wie in einem der Ansprüche 1 bis 6 definiert, wenigstens ein organisches Lösungsmittel, gegebenenfalls ein Bindemittelharz und gegebenenfalls ein Dispergiermittel.

8. Photolack, enthaltend wenigstens ein photohärtbares Monomer, wenigstens einen Photoinitiator und wenigstens ein Pigment, wie in einem der Ansprüche 1 bis 6 definiert.

9. Verfahren zur Herstellung von Farbfiltern für Flüssigkristallanzeigen, dass die Verwendung von wenigstens einem Pigment, wie in einem der Ansprüche 1 bis 6 definiert, umfasst.

10. Verfahren zur Herstellung von Farbfiltern für Flüssigkristallanzeigen, **dadurch gekennzeichnet, dass** wenigstens Pigment, wie in einem der Ansprüche 1 bis 6 definiert, in einem organischen Lösungsmittel gegebenenfalls unter Zusatz eines Bindemittelharzes und/oder Dispergiermittels gemahlen wird, anschließend unter Zusatz von photohärtbaren Monomeren, Photoreaktionsstarter und gegebenenfalls weiterem Bindemittel und/oder Lösungsmittel zu einem Photolack verarbeitet wird, der im Anschluss daran auf ein Substrat aufgetragen wird, mittels Photomaske belichtet und anschließend gehärtet und zum fertigen Farbfilter entwickelt wird.

11. Farbfilter, enthaltend wenigstens ein Pigment, wie in einem der Ansprüche 1 bis 6 definiert.

12. Flüssigkristallanzeige, enthaltend wenigstens einen Farbfilter gemäß Anspruch 10.

13. Verwendung eines Pigments, wie in einem der Ansprüche 1 bis 6 definiert, in Drucktinten zur Herstellung von Farbfiltern, insbesondere nach dem Verfahren der Photolithographie, Offset-Druck oder dem Verfahren des mechanischen, piezo-mechanischen oder thermischen Ink-Jet Drucks.

14. Verwendung gemäß Anspruch 13, **dadurch gekennzeichnet, dass** die Drucktinten zusätzlich ein wässrig-organisches Trägermedium enthalten.

## Claims

1. Use of pigments of the formula (I) 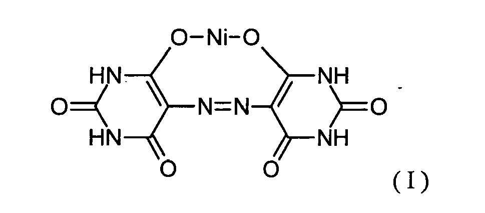 or tautomeric structures thereof and/or hydrates thereof, containing melamine as guest compound, as pigments for colour filters for liquid-crystal displays, **characterized in that** the said pigments have a dispersion harshness of more than 250.

2. Use according to Claim 1, wherein the pigment is used together with Pigment Green 36 pigment.

3. Use of pigments according to Claim 1 or 2, **characterized in that** they contain two molecules of melamine per atom of nickel.

4. Use of pigments according to one of Claims 1 to 3, **characterized in that** the pigments are heat-treated, preferably heat-treated at a pH of 2.5-3.5.

5. Use of pigments according to one of Claims 1 to 4, **characterized in that** they have a dispersion harshness of more than 250 and less than 1000.

6. Use of pigments according to one of Claims 1 to 5, **characterized in that** they have a BET specific surface area of 120 to 180 m²/g.

7. Preparations comprising at least one pigment as defined in one of Claims 1 to 6, at least one organic solvent, optionally a binder resin and optionally a dispersant.

8. Photoresist comprising at least one photocurable monomer, at least one photoinitiator and at least one pigment as defined in one of Claims 1 to 6.

9. Process for producing colour filters for liquid-crystal displays, comprising the use of at least one pigment as defined in one of Claims 1 to 6.

10. Process for producing colour filters for liquid-crystal displays, **characterized in that** at least one pigment as defined in one of Claims 1 to 6 is ground in an organic solvent, optionally with addition of a binder resin and/or dispersant, then processed to a photoresist with addition of photocurable monomers, photoreaction initiator and, optionally, further binder and/or solvent, the photoresist being subsequently applied to a substrate, exposed by means of a photomask and then cured and developed to form the ready-produced colour filter.

11. Colour filter comprising at least one pigment as defined in one of Claims 1 to 6.

12. Liquid-crystal display comprising at least one colour filter according to Claim 10.

13. Use of a pigment as defined in one of Claims 1 to 6 in printing inks for producing colour filters, in particular by the method of photolithography, offset printing or mechanical, piezomechanical or thermal ink-jet printing.

14. Use according to Claim 13, **characterized in that** the printing inks further comprise an aqueous-organic vehicle.

## Revendications

1. Utilisation de pigments de formule (I) 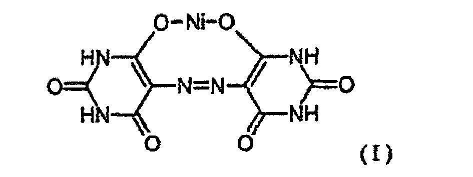 ou de structures tautomères de ceux-ci et/ou d'hydrates de ceux-ci, dans lesquels de la mélamine est incorporée, comme pigment pour des filtres couleur pour affichages à cristaux liquides, **caractérisée en ce que** les pigments mentionnés présentent une facilité de dispersion supérieure à 250.

2. Utilisation selon la revendication 1, dans laquelle le pigment est utilisé conjointement avec le pigment "Pigment Green 36".

3. Utilisation de pigments selon la revendication 1 ou 2, **caractérisée en ce qu'**ils contiennent, par atome de nickel deux molécules de mélamine.

4. Utilisation de pigments selon l'une quelconque des revendications 1 à 3, **caractérisée en ce qu'**il s'agit de pigments traités thermiquement, de préférence traités thermiquement à pH 2,5-pH 3,5.

5. Utilisation de pigments selon l'une quelconque des revendications 1 à 4, **caractérisée en ce qu'**ils présentent une facilité de dispersion supérieure à 250 et inférieure à 1000.

6. Utilisation de pigments selon l'une quelconque des revendications 1 à 5, **caractérisée en ce qu'**ils présentent une surface spécifique selon BET de 120 à 180 m²/g_{.}

7. ompositions contenant au moins un pigment selon l'une quelconque des revendications 1 à 6, au moins un solvant organique, le cas échéant une résine de liant et le cas échéant un dispersant.

8. Photolaque, contenant au moins un monomère photodurcissable, au moins un photo-initiateur et au moins un pigment selon l'une quelconque des revendications 1 à 6.

9. Procédé pour la production de filtres couleur pour affichages à cristaux liquides qui comprend l'utilisation d'au moins un pigment selon l'une quelconque des revendications 1 à 6.

10. Procédé pour la production de filtres couleur pour affichages à cristaux liquides, **caractérisé en ce qu'**on broie au moins un pigment selon l'une quelconque des revendications 1 à 6, dans un solvant organique, le cas échéant avec addition d'une résine de liant et/ou d'un dispersant, on transforme ensuite avec addition de monomères photodurcissables, d'initiateurs de photoréaction et le cas échéant de liant supplémentaire et/ou d'un solvant en une photolaque qui est ensuite appliquée sur un substrat, éclairée au moyen d'un photomasque et ensuite durcie et développée en filtre couleur fini.

11. Filtre couleur contenant au moins un pigment selon l'une quelconque des revendications 1 à 6.

12. Affichages à cristaux liquides contenant au moins un filtre couleur selon la revendication 10.

13. Utilisation d'un pigment selon l'une quelconque des revendications 1 à 6 dans des encres d'imprimerie pour la production de filtres couleur, en particulier selon le procédé de la photolithographie, l'impression offset ou le procédé d'impression par jet d'encre mécanique, piézo-mécanique ou thermique.

14. Utilisation selon la revendication 13, **caractérisée en ce que** les encres d'imprimerie contiennent en outre un milieu support aqueux-organique.
